# FASCICULE DE BREVET EUROPEEN

(11) **EP 2 543 136 B1**
(45) Date de publication et mention de la délivrance du brevet: **08.03.2017**
(21) Numéro de dépôt: 10719533.1
(22) Date de dépôt: 16.03.2010
(51) Int. Cl.: H03F 1/08, H03F 1/30, H03F 1/32

(54) **CONVERTISSEUR COURANT-TENSION À RÉFLECTEUR DE COURANT, ÉTAGE D'ENTRÉE D'UN AMPLIFICATEUR ET AMPLIFICATEUR CORRESPONDANT**
STROMSAPNNUNGSWANDLER MIT STROMREFLEKTOR, EINGANGSSTUFE EINES VERSTÄRKERS UND ENTSPRECHENDER VERSTÄRKER
CURRENT-VOLTAGE CONVERTER HAVING A CURRENT REFLECTOR, INPUT STAGE OF AN AMPLIFIER AND CORRESPONDING AMPLIFIER

(30) Priorité: 03.03.2010 FR 1051541
(43) Date de publication de la demande: 09.01.2013
(73) Titulaire: Devialet, 75001 Paris (FR)
(72) Inventeur: MORONVALLE, Mathias, F-91430 Vauhallan (FR); CALMEL, Pierre-Emmanuel, F-78000 Versailles (FR)
(74) Mandataire: Lavoix
(86) Numéro de dépôt international: PCT/FR2010/050473
(87) Numéro de publication internationale: WO 2011/107671

(56) Documents cités:
- US-B1- 6 963 244
- US-B1- 7 164 317

## Description

La présente invention concerne un convertisseur courant-tension à réflecteur de courant, le courant d'entrée comportant une composante fixe et une composante variable, le convertisseur comportant :
- une entrée pour le courant à convertir ;
- une sortie pour la tension convertie ;
- une résistance de conversion du courant en tension agencée entre la sortie et la masse, l'entrée étant reliée à la sortie pour la circulation du courant à convertir dans la résistance ; et
- un circuit réflecteur de courant comportant deux sources de courant constant reliées chacune entre la sortie et une tension de référence respective

Un tel convertisseur trouve son application en particulier dans un amplificateur haute fidélité à haute linéarité et à faible taux de distorsion thermique. Il est courant, dans un tel amplificateur, d'utiliser en entrée, un convertisseur numérique-analogique tel que le composant PCM 1792 de la société Texas Instrument. Ce convertisseur possède une sortie en courant, de sorte que le signal analogique est modulé en intensité.

Dans la mesure où l'étage d'amplification placé en aval utilise en entrée une tension modulée, il convient de disposer un convertisseur courant-tension entre le convertisseur analogique-numérique et l'étage d'amplification proprement dit.

Les convertisseurs numérique-analogique à sortie en courant sont particulièrement appréciés puisqu'ils sont insensibles à la distorsion thermique, ceux-ci fonctionnant à puissance constante.

En effet, les sources de courant sont commutées entre la masse ou une sortie fixée à une masse virtuelle réalisée traditionnellement par un montage à amplificateur opérationnel. De cette manière, tous les transistors du convertisseur fonctionnent à courant et tension constants, donc à puissance constante, quelque soit la modulation du signal de sortie.

Cependant, la difficulté de préserver cette absence de distorsion thermique est reportée sur les deux étages suivants, à savoir, le convertisseur courant-tension et l'étage de gain de tension associé. Traditionnellement, le convertisseur courant-tension est réalisé à partir d'un montage à amplificateur opérationnel dont la sortie est limitée à quelques volts d'amplitude. L'amplificateur opérationnel est suivi d'un montage à transistors pour assurer une élévation de la tension.

Ces solutions, bien qu'elles soient complexes et coûteuses dégradent toutefois significativement les performances initiales en introduisant de la distorsion harmonique et thermique, du retard et de la distorsion d'inter-modulation et de transitoire, dus notamment à l'amplificateur opérationnel.

US 7 164 317 et US 6 963 244 décrivent des convertisseurs courant-tension de l'état de la technique.

L'invention a pour but de réaliser un convertisseur courant-tension incorporant un étage de gain, qui dégrade moins les performances du convertisseur numérique-analogique tel que le PCM 1792 placé en amont.

A cet effet, l'invention a pour objet un convertisseur courant-tension à réflecteur de courant du type précité, caractérisé en ce qu'il comporte un étage cascode monté en série avec chaque générateur de courant constant pour imposer une différence de potentiel constante aux bornes de chaque générateur de courant constant quelle que soit la tension de sortie.
Suivant des modes particuliers de réalisation, le convertisseur comporte l'une ou plusieurs des caractéristiques suivantes :
- le convertisseur comporte un étage cascode monté en série à l'entrée pour le courant à convertir ;
- l'entrée pour le courant à convertir est reliée à la sortie au travers de l'un des étages cascode montés en série avec les générateurs de courant constant ;
- le convertisseur comporte, pour chaque étage cascode, des moyens de réinjection d'un courant égal au courant absorbé dans le circuit réflecteur de courant ;
- le convertisseur comporte, pour chaque étage cascode, des moyens de mesure du courant absorbé pour l'étage cascode ;
- les moyens de mesure du courant comportent un circuit miroir de courant de mesure monté sur le circuit de commande de la grille de chaque transistor d'un étage cascode, et les moyens de réinjection du courant absorbé dans le circuit réflecteur de courant comprennent des moyens de sommation et d'inversion du signe des deux courants obtenus en sortie des miroirs de courant de mesure, la sortie des moyens de sommation et d'inversion étant connectée au circuit miroir de courant pour l'injection dans le circuit réflecteur de courant de l'opposé de la somme de courants obtenus en sortie des circuits miroir de courant de mesure ;
- les moyens de sommation et d'inversion du signe des deux courants obtenus en sortie des miroirs de courant de mesure comprennent pour chaque miroir de courant, un miroir de courant d'inversion de signe monté en série, les sorties des deux miroirs de courant d'inversion de signe étant reliées ensemble au circuit réflecteur de courant ;
- les moyens de réinjection du courant absorbé comportent des moyens d'injection d'un signal de connexion dans le générateur de courant associé à l'étage cascode pour que le générateur de courant fournisse un courant augmenté du courant absorbé par l'étage cascode;
- les moyens de réinjection sont propres à réinjecter un courant égal au courant absorbé dans le circuit réflecteur de courant pour les fréquences audibles, telles que les fréquences inférieures à 20 kHz, et le convertisseur comporte des moyens de stabilisation de la tension délivrée sur la sortie afin de réduire le taux de réinjection du courant pour les fréquences supérieures aux fréquences audibles, telles que les fréquences supérieures à 20 kHz, le taux de réinjection étant égal à la quantité de courant réinjecté divisée par la quantité de courant absorbé ;
- les moyens de stabilisation comportent un filtre passe-bas ;
- le convertisseur est dépourvu d'amplificateur opérationnel.
- la différence d'intensité entre les deux sources de courant constant est égale à la composante fixe du courant d'entrée.

L'invention a également pour objet un étage d'entrée d'un amplificateur haute fidélité à haute linéarité et faible taux de distorsion comportant un convertisseur numérique-analogique à sortie en courant et un convertisseur courant-tension tel que défini ci-dessus.

L'invention a également pour objet un amplificateur haute fidélité à haute linéarité et faible taux de distorsion comportant un étage d'entrée tel que défini ci-dessus et un étage d'amplification, aucun étage de gain de tension n'étant interposé entre le convertisseur courant-tension et l'étage d'amplification.

Suivant un mode particulier de réalisation, l'amplificateur comporte la caractéristique suivante :
- la résistance de conversion présente une valeur supérieure ou égale à la différence entre les valeurs extrêmes de la tension en sortie de l'étage d'amplification divisée par la différence entre les valeurs extrêmes de l'intensité du courant en entrée du convertisseur courant-tension.

L'invention sera mieux comprise à la lecture de la description qui va suivre, donnée uniquement à titre d'exemple et faite en se référant aux dessins sur lesquels :
- la figure 1 est une vue schématique d'un amplificateur haute fidélité selon l'invention ;
- la figure 2 est un schéma électrique du convertisseur courant-tension de l'amplificateur de la figure 1 suivant l'art du métier;
- les figures 3 et 4 sont des schémas électriques de variantes de réalisation, selon l'invention du convertisseur courant-tension de la figure 2 ; et
- la figure 5 est un ensemble de courbes illustrant les réponses fréquentielles pour les deux modes de réalisation des figures 3 à 4 du convertisseur courant-tension.

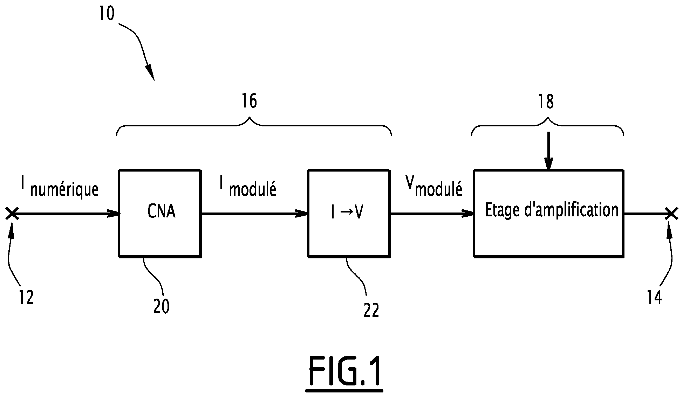

L'amplificateur 10, représenté schématiquement sur la figure 1, est un amplificateur haute fidélité propre à recevoir sur une entrée 12 un signal numérique et à produire en sortie 14 un signal analogique amplifié.

Comme connu en soi , l'amplificateur comporte un étage d'entrée 16 assurant la conversion du signal numérique d'entrée en un signal analogique de sortie modulé en tension, ainsi qu'un étage d'amplification 18, assurant la fourniture d'une puissance suffisante pour la charge placée en aval, à savoir un ou plusieurs hauts parleurs. Il s'agit de préférence d'un étage d'amplification de classe A.

L'étage d'entrée 16 comporte un convertisseur numérique-analogique 20 dont l'entrée est reliée à l'entrée 12 de l'amplificateur pour recevoir un signal numérique I_{numérique}. Ce convertisseur numérique-analogique est propre à fournir en sortie un signal analogique modulé en courant I_{modulé}. Le convertisseur numérique-analogique est par exemple un PCM 1792 de la société Texas Instrument.

La sortie du convertisseur numérique-analogique 20 est reliée à un convertisseur courant-tension 22 selon l'invention.

Ce convertisseur est propre à fournir une tension V_{modulé} modulée et avec un gain de tension à partir du courant modulé I_{modulé} produit par le convertisseur numérique-analogique 20. La sortie du convertisseur 22 est reliée à l'entrée de l'étage d'amplification 18 comme connu en soi.

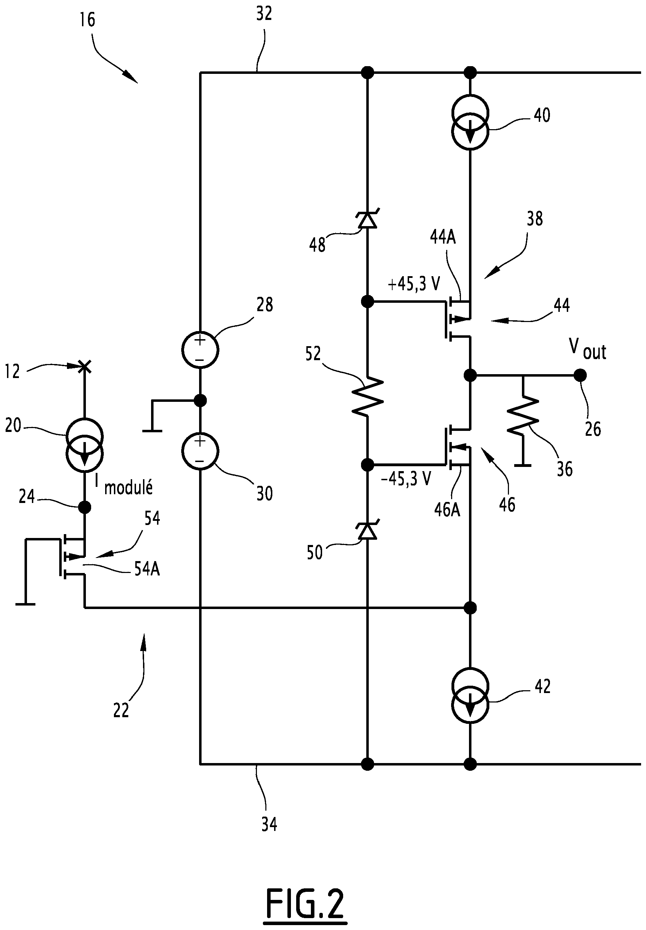

Sur la figure 2 est illustré l'étage d'entrée 16. Sur cette vue, le convertisseur numérique-analogique 20 est schématisé par une source de courant.

Le convertisseur courant-tension 22 présente une entrée 24 reliée en sortie du convertisseur numérique-analogique 20 et une sortie de tension 26 propre à être reliée directement à l'étage d'amplification 18.

Le convertisseur courant-tension 22 comporte deux sources de tension 28, 30 dont une borne est reliée à la masse et dont l'autre borne alimente deux bus de tension continue respectivement 32, 34, l'un étant maintenu à un potentiel constant de +50 V et l'autre maintenu à une tension constante de -50 V par rapport à la masse.

Le convertisseur courant-tension 22 comporte une résistance de conversion 36, dont une borne est reliée à la sortie 26, et dont l'autre borne est reliée à la masse.

L'entrée 24 du convertisseur est reliée à la borne de la résistance 36 constituant la sortie 26 du convertisseur au travers d'un circuit réflecteur de courant 38 propre à assurer une transmission de l'intégralité du courant de modulation I_{modulé} produit par la convertisseur numérique-analogique jusqu'à la résistance de conversion 36 référencée à la masse sans que le courant de modulation du convertisseur numérique-analogique ne soit modifié ou soumis à une distorsion thermique.

Comme connu en soi, le courant de sortie du convertisseur numérique-analogique 22 comprend une composante continue de 6,2 mA et une composante variable variant entre -4 et +4 mA.

Le circuit réflecteur de courant 38 est propre à annuler la composante continue.

A cet effet, et comme connu en soi, le circuit réflecteur de courant comporte un premier générateur de courant constant 40 reliant le bus continu 32 à la sortie 26 et un second générateur de courant constant 42 reliant la sortie 26 au bus de tension 24.

Idéalement, les générateurs de courant 40 et 42 sont des générateurs de courant parfaits, le générateur 40 étant propre à fournir une intensité supérieure à 6,2 mA et le générateur de courant 42 étant propre à fournir une intensité égale à celle du générateur 40 augmenté de 6,2 mA.

Dans ces conditions, la composante variable du courant de sortie du convertisseur numérique-analogique 20 se trouve intégralement dirigée dans la résistance 36, réalisant une conversion courant-tension dont la limitation de linéarité ne réside que dans les défauts de la résistance 36.

La résistance de conversion 36 présente une valeur supérieure ou égale à la différence entre les valeurs extrêmes de la tension en sortie de l'étage d'amplification 18 divisée par la différence entre les valeurs extrêmes de l'intensité I_{modulé} du courant en entrée du convertisseur courant-tension 22.

Un premier étage cascode 44 est monté en série entre le générateur 40 et la sortie 26. De même, un second étage cascode 46 est interposé entre la source courant 42 et la sortie 26.

Ces deux étages cascode comportent chacun un transistor MOS 44A, 46A dont le drain est relié à la sortie 26 et dont la source est reliée au générateur de courant 40 et 42. Les grilles des deux transistors 40, 46 sont maintenus chacun à une tension fixe de + 45,3 V et - 45,3 V, respectivement pour les transistors 44 et 46. A cet effet, les grilles des transistors 44, 46 sont reliés respectivement aux bus de tension 32, 34 par une diode zéner 48, 50. Une résistance 52 assurant la circulation d'un courant de faible intensité au travers des diodes 48, 50 relie l'anode de la diode 48 à la cathode de la diode 50. Cette résistance a par exemple une valeur de 100 kΩ.

De préférence, l'entrée 24 du convertisseur courant-tension est reliée entre l'étage cascode 46 et le générateur de courant 42.

En outre, un étage cascode supplémentaire 54 est disposé entre l'entrée 24 du convertisseur et le circuit réflecteur de courant 38 auquel elle est connectée. Cet étage cascode comporte un transistor 54A de type MOS dont la source est reliée à l'entrée 24. Le drain est relié au circuit réflecteur de courant 38 et la grille est reliée à la masse.

On comprend que les étages cascode 44 et 46 permettent que les sources de courant 40, 42 ne présentent pas de variation de tension à leur bornes quand la tension de sortie au point 26 varie même de plusieurs de dizaines de Volt.

Les étages cascode 44, 46 garantissent que les différences de tension aux bornes de générateur de courant 40, 42 soient constamment égales à 2,7 V, quelque soit la tension de sortie du circuit. Cette tension aux bornes de générateur de courant étant fixée à la tension fixe de 4,7 V aux bornes des diodes 48, 50 diminuée de la tension fixe par exemple égale à 2 V entre la grille et la source de chaque transistor 44A, 46A.

De même, l'étage cascode 54 garantit que la tension à la sortie du convertisseur numérique-analogique 20 soit maintenue dans la plage de 0 à 5 V, pour palier au fait que le convertisseur numérique-analogique n'agit pas comme une source de courant parfaite.

Le circuit illustré sur la figure 2 fonctionne de manière satisfaisante. Toutefois, la présence des étages cascode 44, 46 introduit des perturbations du fait de la présence de condensateurs parasites dans les transistors d'une part entre le drain et la grille et d'autre part entre la source et la grille. Ces condensateurs subissent une charge et décharge lorsque la tension à la sortie 26 varie.

Ces phénomènes génèrent des courants d'erreur qui viennent s'ajouter ou se retrancher au courant issu du convertisseur numérique-analogique. Le courant circulant jusqu'à la résistance 36 et donc la tension à ses bornes lue depuis la sortie 26 s'en trouve modifiée. L'importance de ce phénomène est proportionnelle à la fréquence du signal converti car les courants dans les condensateurs dépendent de la dérivée de la tension à la sortie 26.

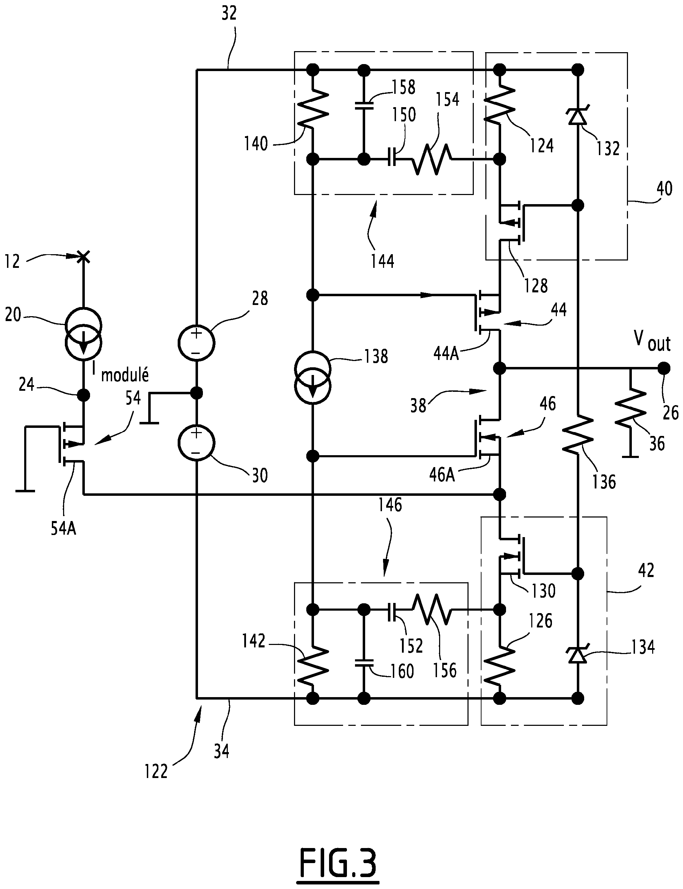

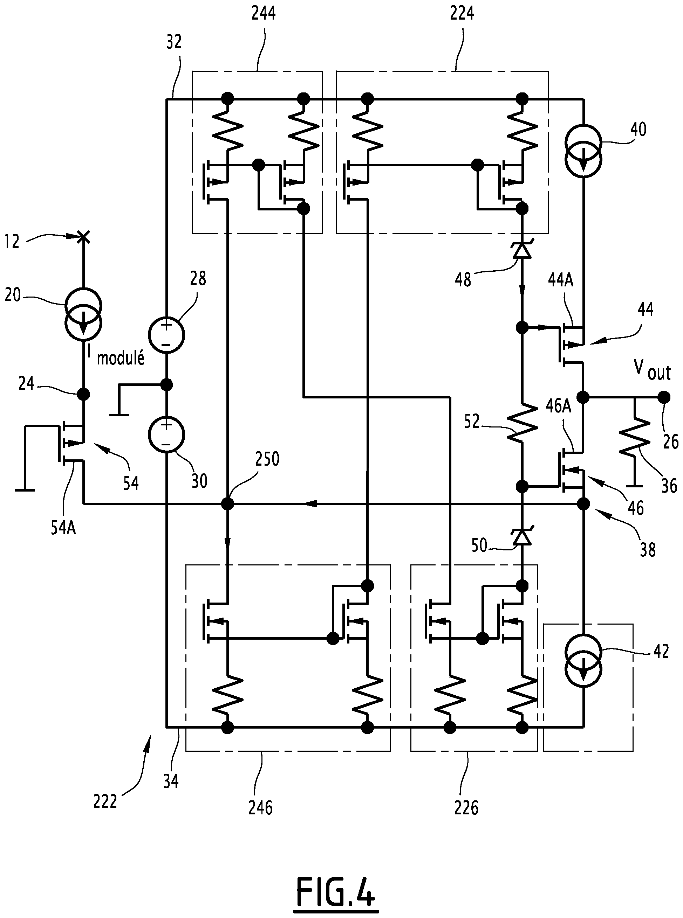

Les montages des figures 3 et 4 apportent une solution à la charge et décharge des condensateurs parasites en supprimant la distorsion harmonique en résultant, laquelle peut atteindre un niveau relativement élevé de l'ordre de - 70 dBc.

La figure 3 reprend les éléments de la figure 2 complétée par des éléments additionnels. Les éléments identiques ou correspondant à ceux de la figure 2 sont désignés par les mêmes numéros de référence et ne seront pas décrits en détail à nouveau, puisqu'ils sont connectés de manière identique.

Dans ce mode de réalisation, les générateurs de courant constant 40, 42 sont formés chacun d'une résistance 124 , 126 dont une borne est reliée au bus de tension 32, 34 respectif, et l'autre borne est reliée à l'étage cascode 44, 46 associé, au travers d'un transistor 128, 130 de type MOS dont la grille est reliée respectivement au bus de tension 32 et 34 par une diode zéner respectivement 132, 134. Les grilles et anodes des diodes 132, 134 sont reliées par une résistance 136 propre à assurer la circulation d'un courant au travers des diodes 132, 134 en polarisation inverse ou zéner.

Dans ce mode de réalisation, les grilles des transistors 44A, 46A des étages cascode 44, 46 sont reliées entre elles par un générateur de courant 138 propre à établir un courant constant de l'ordre de 0,8 mA. La borne du générateur de courant 138, connectée à la grille du transistor 44 est reliée au bus de tension par une résistance 140 alors que l'autre borne du générateur reliée à la grille du transistor 46A est reliée au bus de tension 44 par une résistance 142.

Le circuit de la figure 3 comporte des moyens 144, 146 de mesure du courant absorbé par l'étage cascode 44, 46 et des moyens pour réinjecter un courant égal au courant absorbé dans le circuit réflecteur de courant 38.

Ces moyens 144, 146 sont formés, dans le mode de réalisation de la figure 3, par une liaison comprenant respectivement en série un condensateur 150, 152 et une résistance 154, 156. Cette liaison relie la grille des transistors 44A, 46A aux bornes des résistances 124, 126 reliées aux étages cascode 44, 46 au travers des transistors 128, 130.

Les moyens de réinjection sont, par exemple, propres à réinjecter un courant égal au courant absorbé dans le circuit réflecteur de courant 38 pour les fréquences audibles, telles que les fréquences inférieures à 20 kHz, et les circuits 144, 146 comportent des moyens de stabilisation de la tension délivrée sur la sortie 26 afin de réduire le taux de réinjection du courant pour les fréquences supérieures aux fréquences audibles, telles que les fréquences supérieures à 20 kHz. Le taux de réinjection est égal à la quantité de courant réinjecté divisée par la quantité de courant absorbé. Dans l'exemple de réalisation de la figure 3, un condensateur 158, 160 est disposé entre chaque bus de tension 32, 34 et la grille des transistors 44A, 46A. Ces condensateurs 158, 160 forment, avec les résistances 154, 156, un filtre passe bas, évitant la correction pour les fréquences supérieures aux fréquences audibles.

En variante, les circuits 144, 146 ne comportent pas de condensateur disposé entre chaque bus de tension 32, 34 et la grille des transistors 44A, 46A, la correction étant alors également effectuée pour les hautes fréquences, telles que les fréquences supérieures à 20 kHz.

Ainsi, les circuits 144, 146 agissent pour corriger les générateurs de courant 40, 42, en imposant à ceux-ci de réinjecter un courant égal au courant absorbé par les capacités parasites des transistors 44A, 46A.

Les circuits 144 et 146 agissent comme un piège à courant d'erreur, le courant d'erreur étant le courant à travers les grilles des transistors 44A et 46A qui aurait dû idéalement rester à travers le dipôle drain-source de ces transistors. Ce courant est piégé en ce sens qu'il est réinjecté, à l'intérieur des sources de courant 40 et 42, dans la branche même de laquelle il s'est échappé, la jonction drain-source des transistors 44A et 46A, jonction qui véhicule le courant sommé à travers la résistance de sortie 36.

Sur la figure 4 est représenté encore un autre mode de réalisation dans lequel les éléments identiques ou correspondant à ceux de la figure 2 sont désignés par les mêmes numéros de référence.

Dans ce mode de réalisation, les moyens de mesure du courant absorbé par chaque étage cascode 44, 46 comportent un circuit miroir de courant 224, 226 dont la branche d'entrée est placée sur le circuit de commande de la grille de chaque transistor 44A, 46A.

Comme connu en soi, chaque circuit miroir de courant comporte deux transistors de type MOS, dont les grilles sont reliées entre elles, le transistor de la branche d'entrée est monté en série avec une résistance et est interposé entre le bus de tension continu 32, 34 et la diode zéner 48, 50. Les branches de sortie des circuits miroir de courant 224, 226 constitués, également d'un transistor en série avec une résistance sont reliés aux branches d'entrée d'un autre circuit miroir de courant 244, 246 formant chacun un inverseur. Ces circuits miroirs de courant ont leurs branches de sortie reliées ensemble au point de connection de l'entrée 24 au circuit réflecteur de courant 38.

Ainsi, les circuits miroir de courant 244, 246 formant un inverseur et dont les sorties sont connectées, assurant une réinjection dans le circuit réflecteur 38 du courant absorbé par les transistors 44A, 46A, ce courant étant mesuré dans les branches de commande de ces transistors par les circuits miroir de courant 224, 226.

On conçoit ainsi que dans ce mode de réalisation, un courant de valeur égale à la somme des courants absorbés par les transistors 44A, 46A est réinjecté dans le circuit réflecteur de courant 38 et donc au travers de la résistance 36, compensant ainsi le courant nécessaire pour la charge ou la décharge des condensateurs parasites des transistors 44A, 46A.

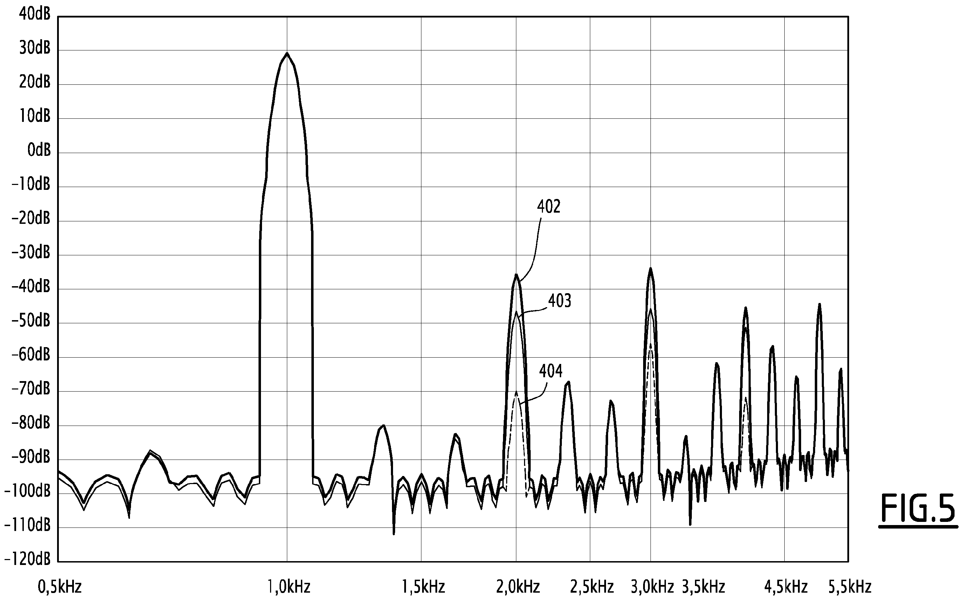

Sur la figure 5 sont représentées les réponses fréquentielles respectives des circuits des figures 2, 3 et 4. Chaque réponse fréquentielle contient une combinaison d'une fréquence fondamentale attendue et de fréquences harmoniques non souhaitées correspondant à la distorsion harmonique de la réponse du circuit. La courbe 402, représentée en trait continu fort, montre la réponse du circuit de la figure 2, la courbe 403 en trait continu fin, la réponse pour le circuit de la figure 3, et la courbe en pointillé, la réponse pour le circuit de la figure 4.

On constate que pour certaines fréquences, telles que les fréquences de 2 et 3 kHz, la réponse est meilleure pour le circuit de la figure 4 utilisant des circuits miroirs de courant pour mesurer et réinjecter le courant absorbé par les transistors, cette réponse étant plus médiocre mais de bonne qualité pour les circuits de la figure 3, alors que le circuit de la figure 2, même s'il conduit à des résultats exploitables, présente une distorsion harmonique plus élevée due à l'absence de correction du courant absorbé par les transistors des étages cascode.

## Revendications

1. Convertisseur (22; 122; 222) courant-tension à réflecteur de courant, le courant d'entrée comportant une composante fixe et une composante variable, le convertisseur comportant :
- une entrée (24) pour le courant à convertir ;
- une sortie (26) pour la tension convertie ;
- deux sources de courant constant (40, 42) reliées chacune entre la sortie (26) et une tension de référence respective (32, 34) ;
- monté en série avec chaque source de courant constant (40, 42), au moins un transistor MOSFET (44A, 46A), dont la grille est reliée à l'une des tensions de référence (32, 34) ; et
- une résistance (36) de conversion du courant en tension agencée entre la sortie (26) et la masse, l'entrée (24) pour le courant à convertir étant reliée à la sortie (26) au travers de l'un des transistors MOSFET (46A) ;
**caractérisé en ce qu'**il comporte, pour chaque transistor MOSFET (44A, 46A), des moyens (150, 154, 152, 156; 244, 246, 250) de réinjection dans l'une au moins des sources de courant (40, 42), d'un courant égal au courant absorbé dans les grilles des transistors MOSFET (44A, 46A).

2. Convertisseur selon la revendication 1, **caractérisé en ce qu'**il comporte, pour chaque transistor MOSFET (44A, 46A), des moyens (224, 226) de mesure du courant absorbé par le transistor MOSFET (44A, 46A).

3. Convertisseur selon la revendication 2, **caractérisé en ce que** les moyens de mesure du courant comportent un circuit miroir de courant de mesure (224, 226) monté sur le circuit de commande de la grille de chaque transistor MOSFET (44A, 46A), et les moyens de réinjection du courant absorbé dans les grilles des transistors MOSFET (44A, 46A) comprennent des moyens (244, 246) de sommation et d'inversion du signe des deux courants obtenus en sortie des miroirs de courant de mesure (224, 226), la sortie des moyens de sommation et d'inversion étant connectée à la source de courant (42) pour ajouter au courant de drain de l'un des transistors MOSFET (46A) l'opposé de la somme des courants obtenus en sortie des circuits miroir de courant (224, 226) de mesure.

4. Convertisseur selon la revendication 3, **caractérisé en ce qu'**il comporte un transistor MOSFET (54A), monté en série à l'entrée (24) pour le courant à convertir, et dont la grille est reliée à une masse électrique.

5. Convertisseur selon la revendication 4, **caractérisé en ce que** les moyens de sommation et d'inversion du signe des deux courants obtenus en sortie des miroirs de courant de mesure (224, 226) comprennent pour chaque miroir de courant (224, 226), un miroir de courant d'inversion de signe (244, 246) monté en série, les sorties des deux miroirs de courant d'inversion de signe (244, 246) étant reliées ensemble au drain du transistor MOSFET (54A) monté en série à l'entrée (24).

6. Convertisseur selon l'une quelconque des revendications précédentes, **caractérisé en ce que** les moyens de réinjection du courant absorbé comportent des moyens (150, 154, 152, 156) d'injection d'un signal de connexion dans la source de courant (40, 42) associé au transistor MOSFET (44A, 46A) pour que la source de courant (40, 42) fournisse un courant augmenté du courant absorbé par le transistor MOSFET (44A, 46A).

7. Convertisseur selon l'une quelconque des revendications précédentes, **caractérisé en ce que** les moyens de réinjection sont propres à réinjecter un courant égal au courant absorbé dans les grilles des transistors MOSFET (44A, 46A) pour les fréquences audibles, telles que les fréquences inférieures à 20 kHz, et **en ce qu'**il comporte des moyens (154, 158, 156, 160) de stabilisation de la tension délivrée sur la sortie (26) afin de réduire le taux de réinjection du courant pour les fréquences supérieures aux fréquences audibles, telles que les fréquences supérieures à 20 kHz, le taux de réinjection étant égal à la quantité de courant réinjecté divisée par la quantité de courant absorbé.

8. Convertisseur selon la revendication 7, **caractérisé en ce que** les moyens de stabilisation comportent un filtre passe-bas (154, 158, 156, 160).

9. Convertisseur selon l'une quelconque des revendications précédentes, **caractérisé en ce qu'**il est dépourvu d'amplificateur opérationnel.

10. Convertisseur selon l'une quelconque des revendications précédentes, **caractérisé en ce que** la différence d'intensité entre les deux sources de courant constant (40, 42) est égale à la composante fixe du courant d'entrée.

11. Etage d'entrée d'un amplificateur haute fidélité à haute linéarité et faible taux de distorsion comportant un convertisseur numérique-analogique à sortie en courant et un convertisseur courant-tension selon l'une quelconque des revendications 1 à 10.

12. Amplificateur haute fidélité à haute linéarité et faible taux de distorsion, **caractérisé en ce qu'**il comporte un étage d'entrée selon la revendication 11, et un étage (18) d'amplification, connecté en série à l'étage d'entrée.

13. Amplificateur selon la revendication 12, **caractérisé en ce que** la résistance de conversion (36) présente une valeur supérieure ou égale à la différence entre les valeurs extrêmes de la tension en sortie de l'étage d'amplification (18) divisée par la différence entre les valeurs extrêmes de l'intensité (Imodulé) du courant en entrée du convertisseur courant-tension (22).

## Patentansprüche

1. Strom-Spannungs-Wandler (22; 122; 222) mit Stromspiegel, wobei der Eingangsstrom eine feste Komponente und eine variable Komponente umfasst, wobei der Wandler Folgendes umfasst:
- einen Eingang (24) für den Strom, der umgewandelt werden soll,
- einen Ausgang (26) für den umgewandelten Strom;
- zwei konstante Stromquellen (40, 42), die jeweils zwischen dem Ausgang (26) und einer entsprechenden Referenzspannung (32, 34) verbunden sind;
- in Reihe mit jeder konstanten Stromquelle (40, 42) montiert, mindestens einen MOSFET-Transistor (44A, 46A), dessen Gate mit einer der Referenzspannungen (32, 34); verbunden ist; und
- einen Widerstand (36) zur Umwandlung des Stroms in Spannung, der zwischen dem Ausgang (26) und der Masse angeordnet ist, wobei der Eingang (24) für den Strom, der umgewandelt werden soll, mit dem Ausgang (26) durch einen der MOSFET-Transistoren (46A) verbunden ist;
**dadurch gekennzeichnet, dass** er für jeden MOSFET-Transistor (44A, 46A) Mittel (150, 154, 152, 156; 244, 246, 250) zur Reinjektion in mindestens eine der Stromquellen (40, 42) eines Stroms umfasst, der gleich dem Strom ist, der in den Gates der MOSFET-Transistoren (44A, 46A) aufgenommen ist.

2. Wandler nach Anspruch 1, **dadurch gekennzeichnet, dass** er für jeden MOSFET-Transistor (44A, 46A) Mittel (224, 226) zum Messen des Stroms umfasst, der vom MOSFET-Transistor (44A, 46A) aufgenommen ist.

3. Wandler nach Anspruch 2, **dadurch gekennzeichnet, dass** die Mittel zum Messen des Stroms eine Stromspiegel-Messschaltung (224, 226) umfassen, die auf dem Steuerstromkreis des Gates jedes MOSFET-Transistors (44A, 46A) montiert ist, und die Mittel zur Reinjektion des Stroms, der in den Gates der MOSFET-Transistoren (44A, 46A) aufgenommen ist, Mittel (244, 246) zur Summierung und zur Umkehrung des Vorzeichens der zwei Ströme, die am Ausgang der Messstromspiegel (224, 226) erhalten wurde, umfassen, wobei der Ausgang der Mittel zur Summierung und Umkehrung mit der Stromquelle (42) verbunden ist, um dem Drain-Strom eines der MOSFET-Transistoren (46A) die Umkehrung der Summe der Ströme hinzuzufügen, die am Ausgang der Messstromspiegel (224, 226) erhalten wurden.

4. Wandler nach Anspruch 3, **dadurch gekennzeichnet, dass** er einen MOSFET-Transistor (54A) umfasst, der in Reihe am Eingang (24) für den Strom, der gewandelt werden soll, montiert ist, und dessen Gate mit einer elektrischen Masse verbunden ist.

5. Wandler nach Anspruch 4, **dadurch gekennzeichnet, dass** die Mittel zur Summierung und zur Umkehrung des Vorzeichens der zwei Ströme, die am Ausgang der Messstromspiegel (224, 226) erhalten wurden, für jeden Stromspiegel (224, 226) einen Stromspiegel zur Umkehrung des Vorzeichens (224, 246), in Reihe montiert, umfassen, wobei die Ausgänge der zwei Stromspiegel zur Umkehrung des Vorzeichens (244, 246) zusammen mit dem Drain des MOSFET-Transistors (54A), der am Eingang (24) in Reihe montiert ist, verbunden sind.

6. Wandler nach einem der vorhergehenden Ansprüche, **dadurch gekennzeichnet, dass** die Mittel zur Reinjektion des aufgenommenen Stroms Mittel (150, 154, 152, 156) zur Injektion eines Verbindungssignals in die Stromquelle (40, 42) umfassen, die mit dem MOSFET-Transistor (44A, 46A) verbunden ist, damit die Stromquelle (40, 42) einen erhöhten Strom des Stroms liefert, der durch den MOSFET-Transistor (44A, 46A) aufgenommen ist.

7. Wandler nach einem der vorhergehenden Ansprüche, **dadurch gekennzeichnet, dass** die Mittel zur Reinjektion geeignet sind, um einen Strom zu reinjizieren, der gleich dem Strom ist, der in den Gates der MOSFET-Transistoren (44A, 46A) für die hörbaren Frequenzen aufgenommen ist, wie z. B. den Frequenzen von weniger als 20 kHz, und dadurch, dass er Mittel (154, 158, 156, 160) zur Stabilisierung der Spannung umfasst, die auf dem Ausgang (26) abgegeben wird, um die Rate der Reinjektion des Stroms für die Frequenzen zu reduzieren, die höher als die hörbaren Frequenzen sind, wie z. B. den Frequenzen von mehr als 20 kHz, wobei die Rate der Reinjektion gleich der Menge des reinjizierten Stroms ist, dividiert durch die Menge des aufgenommenen Stroms.

8. Wandler nach Anspruch 7, **dadurch gekennzeichnet, dass** die Mittel zur Stabilisierung einen Tiefpassfilter (154, 158, 156, 160) umfassen.

9. Wandler nach einem der vorhergehenden Ansprüche, **dadurch gekennzeichnet, dass** er keinen Betriebsverstärker umfasst.

10. Wandler nach einem der vorhergehenden Ansprüche, **dadurch gekennzeichnet, dass** der Intensitätsunterschied zwischen den zwei konstanten Stromquellen (40, 42) gleich der festen Komponente des Eingangsstroms ist.

11. Eingangsstufe eines High-Fidelity-Verstärkers mit hoher Linearität und geringer Distorsionsrate, umfassend einen Digital-Analog-Wandler am Stromausgang und einen Strom-Spannungs-Wandler nach einem beliebigen der Ansprüche 1 bis 10.

12. High-Fidelity-Verstärker mit hoher Linearität und geringer Distorsionsrate, **dadurch gekennzeichnet, dass** er eine Eingangsstufe nach Anspruch 11 und eine Verstärkerstufe (18) umfasst, die in Reihe mit der Eingangsstufe verbunden ist.

13. Verstärker nach Anspruch 12, **dadurch gekennzeichnet, dass** der Umwandlungswiderstand (36) einen Wert aufweist, der größer oder gleich dem Unterschied zwischen den Extremwerten der Spannung am Ausgang der Verstärkerstufe (18), dividiert durch den Unterschied zwischen den Extremwerten der Intensität (Imoduliert) des Stroms am Eingang des Strom-Spannungs-Wandlers (22) ist.

## Claims

1. A current-voltage converter (22; 122; 222) with a current reflector, the input current comprising a fixed component and a variable component, the converter comprising:
- an input (24) for the current to be converted;
- an output (26) for the converted voltage;
- two constant current sources (40, 42) each connected between the output (26) and a respective reference voltage (32, 34);
- at least one MOSFET transistor (44A, 46A), mounted in series with each constant current source (40, 42), and the gate of which is connected to one of the reference voltages (32, 34); and
- a resistor (36) for converting the current into a voltage, arranged between the output (26) and the ground, the input (24) for the current to be converted being connected to the output (26) through one of the MOSFET transistors (46A) ;
**characterized in that** it comprises, for each MOSFET transistor (44A, 46A), means (150, 154, 152, 156; 244, 246, 250) for re-injecting into at least one of the current sources (40, 42), a current equal to the current absorbed in the gates of the MOSFET transistors (44A, 46A).

2. The converter according to claim 1, **characterized in that** it comprises, for each MOSFET transistor (44A, 46A), means (224, 226) for measuring the current absorbed by the MOSFET transistor (44A, 46A).

3. The converter according to claim 2, **characterized in that** the means for measuring the current comprise a measurement current mirror circuit (224, 226) mounted on the circuit for controlling the gate of each MOSFET transistor (44A, 46A), and the means for re-injecting the absorbed current in the gates of the MOSFET transistors (44A, 46A) comprise means (224, 226) for adding both currents obtained at the output of the measurement current mirrors (224, 226) and inverting the sign thereof, the output of the addition and inversion means being connected to the current source (42) for adding to the drain current of one of the MOSFET transistors (46A) the opposite of the sum of the currents obtained at the output of the measurement current mirror circuits (224, 226).

4. The converter according to claim 3, **characterized in that** it comprises a MOSFET transistor (54A), mounted in series at the input (24) for the current to be converted, and the gate of which is connected to an electric ground.

5. The converter according to claim 4, **characterized in that** the means for adding both currents obtained at the output of the measurement current mirrors (224, 226) and inverting the sign thereof comprise for each current mirror (224, 226) a sign inversion current mirror (244, 246) mounted in series, the outputs of both sign inversion current mirrors (244, 246) being connected together to the drain of the MOSFET transistor (54A) mounted in series at the input (24).

6. The converter according to any one of the preceding claims, **characterized in that** the means for re-injecting the absorbed current comprise means (150, 154, 152, 156) for injecting a connection signal into the current source (40, 42) associated with the MOSFET transistor (44A, 46A) so that the current source (40, 42) provides a current increased by the current absorbed by the MOSFET transistor (44A, 46A).

7. The converter according to any one of the preceding claims, **characterized in that** the re-injection means are able to re-inject a current equal to the current absorbed in the gates of the MOSFET transistors (44A, 46A) for audible frequencies, such as frequencies below 20 kHz, and **in that** it comprises means (154, 158, 156, 160) for stabilizing the voltage delivered from the output (26) in order to reduce the re-injection current rate for frequencies above audible frequencies, such as frequencies above 20 kHz, the re-injection rate being equal to the amount of re-injected current divided by the amount of absorbed current.

8. The converter according to claim 7, **characterized in that** the stabilization means comprise a low pass filter (154, 158, 156, 160).

9. The converter according to any one of the preceding claims, **characterized in that** it is without any operational amplifier.

10. The converter according to any one of the preceding claims, **characterized in that** the intensity difference between both constant current sources (40, 42) is equal to the fixed component of the input current.

11. An input stage of a high fidelity amplifier having high linearity and low distortion level comprising a digital-analog converter with a current output and a current-voltage converter according to any one of claims 1 to 10.

12. A high fidelity amplifier having high linearity and low distortion rate, **characterized in that** it comprises an input stage according to claim 11, and an amplification stage (18) connected in series to the input stage.

13. The amplifier according to claim 12, **characterized in that** the conversion resistor (36) has a value greater than or equal to the difference between the extreme values of the output voltage of the amplification stage (18) divided by the difference between the extreme values of the intensity (Imodulated) of the current at the input of the current-voltage converter (22).
